# EUROPEAN PATENT SPECIFICATION

(11) **EP 2 691 562 B1**
(45) Date of publication and mention of the grant of the patent: **08.07.2015**
(21) Application number: 12717800.2
(22) Date of filing: 29.03.2012
(51) Int. Cl.: C30B 23/00, C30B 23/02, C30B 25/08, C30B 25/12, C30B 25/14

(54) **CRYSTAL GROWTH APPARATUS AND METHOD**
VORRICHTUNG UND VERFAHREN ZUR KRISTALLZÜCHTUNG
APPAREIL ET PROCÉDÉ DE CROISSANCE DE CRISTAUX

(30) Priority: 29.03.2011 GB 201105322
(43) Date of publication of application: 05.02.2014
(73) Proprietor: Kromek Limited, Sedgefield, Durham TS21 3FD (GB)
(72) Inventor: ROBINSON, Mark, Shincliffe Durham DH1 2LY (GB); MULLINS, John, Sedgefield Durham TS21 3FD (GB)
(74) Representative: Wilson, Peter
(86) International application number: PCT/GB2012/000292
(87) International publication number: WO 2012/131307

(56) References cited:
- WO-A1-99/10571
- WO-A1-2006/090104
- WO-A1-2008/142395
- JP-A- 6 298 594
- JP-A- 2000 128 699

## Description

### TECHNICAL FIELD

The present invention relates to an apparatus for vapour phase crystal growth.

### BACKGROUND OF THE INVENTION

The present applicants have filed a number of patent applications directed to methods and apparatus for vapour phase crystal growth, including WO 99/10571, WO 2006/090104 and WO 2008/142395.

To grow a crystal by vapour phase crystal growth techniques, it is necessary to provide a source of the materials from which the crystal is to be formed, and a seed onto which the crystal is grown from the source material. A transport zone links the source and sink zones. By creating a temperature difference between the source zone and the sink zone where the seed is provided, a vapour pressure difference will be created between the source and sink zones which acts as the driving force for crystal growth. The temperature of the source zone should be greater than the temperature of the sink zone.

The control of the crystal growth will be dependent on a number of factors, including the source and sink temperatures and the vapour pressures, and the vapour flow over the seed.

In early vapour phase crystal growth systems, (such as for example disclosed in JP2000128699) the crystal was grown on a seed crystal provided in a sealed, tubular, quartz ampoule from source material also provided in the ampoule. The ampoule was provided in a tubular furnace to heat the source and sink zones. However, it is very difficult to control the growth of crystals using such a system.

The provision of a first flow controller between the source and seed zones, in combination with a second flow controller downstream of the seed zone to provide continuous pumping to remove a proportion of the source material from the seed zone was suggested to improve the basic tubular system. The provision of the first flow controller acts to make the mass transport rate less sensitive to the temperature differential between the source and sink zones than in the basic tubular system, although the temperature difference is still an important factor.

An apparatus is disclosed in WO 99/10571 in which independent heating means are provided for each of the source and sink zones. The source and sink zones, together with the independent heating means, are provided in a vacuum chamber. This enables more accurate control of the source and sink temperatures, and therefore of the temperature difference between these zones, to enable a solid-vapour-solid phase transition in the source, transport and sink zones. However, the heating means must be one able to operate in a vacuum. Therefore, heaters such as resistance coil heaters are unsuitable. A flow restrictor can be provided in the transport zone between the source and sink zones to provide additional control.

US 2008/0156255 A1 reported that the gap or degree of spacing provided between the support and the growth chamber can act as a flow restrictor and therefore can affect vapour properties and hence crystal growth. It was suggested that the flow restriction function depended on a combination of the gap size and the length, and therefore that different support and/or growth chamber geometries would give different flow restrictor functions and therefore different crystal growths. The gap between the support and the growth chamber can therefore play an important role in defining the vapour properties and hence growth conditions of a crystal growth apparatus. However, since the support must be positioned in the growth chamber prior to crystal growth, and must be removed from the growth chamber with the crystal after growth, sufficient clearance between the support and the growth chamber is required for this positioning and removal.

### SUMMARY OF THE INVENTION

According to a first aspect of the present invention, there is provided an apparatus for crystal growth, as set forth in claim 1.

By providing a support having a coefficient of thermal expansion which is greater than that of the growth chamber, when the apparatus including the support and the growth chamber is heated to the high temperatures required for vapour phase crystal growth, the relative expansion of the support will be greater than that of the growth chamber. The effect of this relative expansion will be to reduce the gap between the growth chamber and the support at higher temperatures compared to the gap between the support and the growth chamber at lower temperatures. In this way, it is possible to provide a support which is sufficiently smaller than the growth chamber at lower temperatures, for example at ambient temperature, such that there is a sufficient gap between the outside of the support and the inside of the growth chamber to allow the support to be positioned within the growth chamber and moved to the required position easily. As the apparatus is heated, the support and growth chamber will each expand. However, since the coefficient of thermal expansion of the support is greater than the coefficient of thermal expansion of the growth chamber, the support will expand relatively more than the growth chamber, and therefore the gap between the growth chamber and the support will decrease. By appropriately selecting the coefficients of thermal expansions of the support and the growth chamber, the gap between the growth chamber and the support can be accurately and precisely defined for a given temperature value. This allows for accurate and precise calibration of the flow restrictor function of the gap and therefore precise control of the vapour properties and growing conditions within the apparatus, and in particular, within the growth chamber, whilst allowing easy positioning and removal of the support from the growth chamber at lower, ambient, temperatures, with minimal risk of the support impacting against, and potentially damaging or suffering damage from, the growth chamber.

The present invention therefore allows for the support to be easily located within the growth chamber at lower temperatures, for example room temperature, but at higher temperatures, such as operational temperatures, the support can expand relative to the growth chamber to reduce the gap between the growth chamber and the support, to provide precise and desired flow restriction.

Preferably, the support is movable with respect to the growth chamber such that the upper surface of the support and hence the upper surface of the crystal can be moved as the crystal is grown. This allows the position of the upper surface of the crystal on which further crystal material is grown to be adjusted, and therefore its position in the temperature profile can be adjusted. This is of particular advantage when a thick crystal is being formed, as the height of the support can be gradually lowered as the crystal is formed to ensure that the upper surface of the crystal remains at the same position in the temperature profile.

The support may be coupled to or mounted on an elongate shaft. The elongate shaft may have a coefficient of thermal expansion which is the same or similar as that of the support or that of the growth chamber. Alternatively, the elongate shaft may have a coefficient of thermal expansion which is unrelated to the coefficients of thermal expansions of the support and the growth tube. Where the support is coupled to or mounted on an elongate shaft, the support may be controllably moved by coupling the distal end of the elongate shaft to an actuating means, such as a motor.

Preferably the growth chamber and the support respectively have a generally circular cross-sectional area. In this case, the gap between the growth chamber and the support will be in the form of an annulus. When a material expands as a result of an increase in its temperature, it generally expands uniformly in all directions. Therefore, by arranging for the gap to be in the form of an annulus, when the support and the growth tube are heated, they can expand uniformly in all directions and therefore the annulus gap can be reduced uniformly. This ensures that the gap surrounding the support is generally uniform, thereby reducing the chances of the vapour flowing in an uneven manner in and around the seed crystal. Uneven vapour flow can affect the quality of the crystal produced and can have a detrimental effect on its useful properties.

Various materials can be used for the tube and for the pedestal or support. By way of example, the tube can be formed from quartz (which typically has a thermal expansion coefficient of 5.5x10⁻⁷K⁻¹) or from pyrolytic boron nitride (which typically has an in plane thermal expansion coefficient of 1.45x10⁻⁶K⁻¹). Suitable materials for the pedestal may include sapphire (typically having a thermal coefficient of about 7x10⁻⁶K⁻¹), alumina (typically having a thermal coefficient of about 8.5x10⁻⁶K⁻¹), silicon carbide (typically having a thermal coefficient of about 5x10⁻⁶K⁻¹), tungsten (typically having a thermal coefficient of about 4.6x10⁻⁶K⁻¹), tantalum (typically having a thermal coefficient of about 6.6x10⁻⁶K⁻¹) or molybdenum (typically having a thermal coefficient of about 5.7x10⁻⁶K⁻¹). A particular preferred combination in a quartz chamber including a sapphire pedestal.

A flow restrictor may be provided in the transport path to control the vapour flow from the source chamber to the growth chamber.

The apparatus may include one or more additional growth chambers each provided with a respective support and corresponding seed crystal. In this case, each support will have a coefficient of thermal expansion which is greater than the coefficient of thermal expansion of their respective growth chambers. The additional growth chambers may be mutually or independently associated with one or more source chambers.

Where the apparatus includes more than one growth chamber each provided with a respective support and seed crystal, each growth chamber, support and/or seed crystal may be provided with any of the features which have been described above in relation to an apparatus having one growth chamber.

The features associated with each growth chamber may be the same or different as the features associated with the other growth chambers. For example, the coefficient of thermal expansion of a support provided in one growth chamber may be different to the coefficient of thermal expansion of a support provided in one or more other growth chambers. In such a case, at higher temperatures such as operational temperatures, the gap between the support and the growth chamber could vary from chamber to chamber. Since the size of the gap will influence the size of the crystal grown, such an apparatus could be used to simultaneously grow a plurality of crystals having different sizes and properties from one another. According to a second aspect of the present invention there is provided a method as set forth in claim 11.

The method may further include the step of growing a crystal on the support. The method may also include the step of cooling the growth chamber and the support once a crystal has been grown on the support, such that the support contracts with respect to the growth chamber to increase the gap. The method may also include the step of removing the support and the grown crystal from the growth chamber once the gap has increased.

The above method may be carried out using a crystal growth apparatus having any combination of the features described above.

### BRIEF DESCRIPTION OF THE DRAWINGS

Embodiments of the invention will now be described by way of example only with reference to the accompanying drawings, in which:
Figure 1 shows a cross-sectional view of a vapour phase crystal growth apparatus;
Figure 2 shows a cross-sectional view of a support being loaded into a growth chamber, according to a first embodiment of the invention;
Figure 3 shows a cross-sectional view of a support located in a growth chamber at room temperature, according to a first embodiment of the invention;
Figure 4 shows a cross-sectional view of a support located in a growth chamber at operational temperature, according to a first embodiment of the invention;
Figure 5 shows a cross-sectional view of a support located in a growth chamber at operational temperature, where the vapour flow has caused growth of the seed crystal, according to a first embodiment of the invention;
Figure 6 shows a cross-sectional view of a support supporting a grown crystal and being removed from a growth chamber at room temperature, according to a first embodiment of the invention; and
Figures 7A and 7B show s side and plan view respectively of a multi-chamber crystal growth apparatus according to a second embodiment of the present invention.

### DETAILED DESCRIPTION

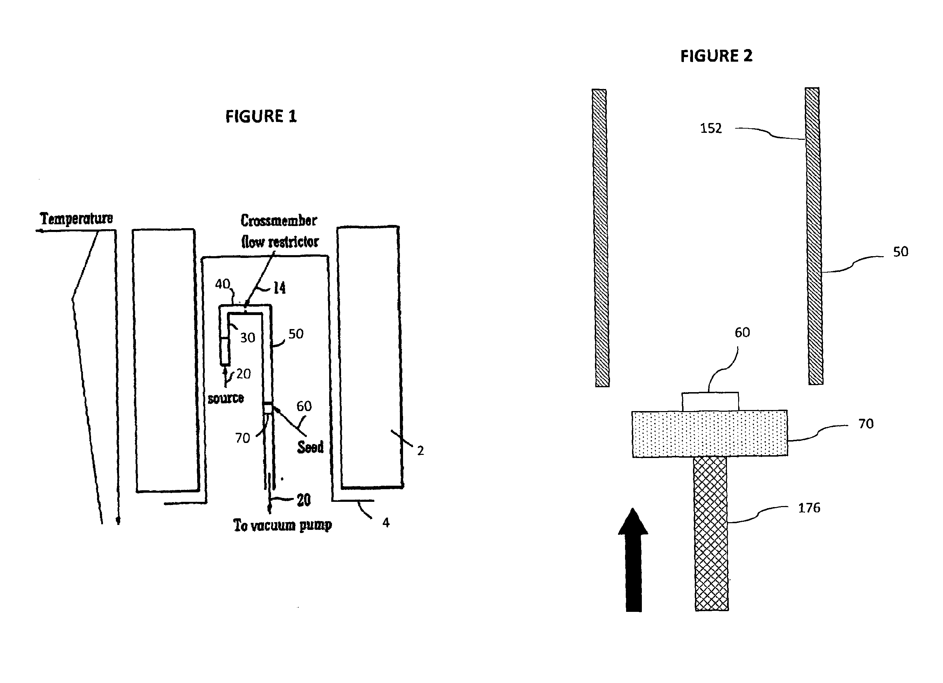

Figure 1 shows a cross-sectional view of a vapour phase crystal growth apparatus. The apparatus includes a source chamber 30 which is provided with a source material 20. This is generally a solid material that is to be vaporised and then conveyed through a transport path in the form of a passage 40 to grow a crystal. A seed crystal 60 is provided in the growth chamber 50. The seed crystal is mounted on a support 70 provided within the growth chamber 50, and is positioned such that an annulus gap surrounds the support 70, separating it from the inner wall of the growth chamber 50.

An annular heater 2 is provided to heat a central heated region. It will be appreciated that the heater does not have to be an annular heater, but could for example be a planar heater arranged to heat the heated region from one side, or could comprise a number of heating elements arranged around the heated region. Optical heaters may also be used.

The heater 2 heats the heated region to provide a predetermined temperature profile. In the example shown, the maximum temperature is towards the top of the heater region, with a decreasing temperature above and below this maximum temperature region. The temperature profile is such that the temperature decreases from the maximum temperature at a greater rate above the maximum temperature region than below the maximum temperature region. In the example shown in Figure 1, the temperature profile is such that the growth chamber region can be at a temperature of around 490°C, the source chamber region at a temperature of around 710°C and the passage at a temperature of around 725 °C. However, it will be appreciated that other temperatures may be selected as appropriate.

When the apparatus of Figure 1 is in operation, the source material 20 will be heated such that it sublimes to form a vapour. The temperature profile of the system causes the vapour to flow from the source chamber 30, via the passage 40, to the growth chamber 50 and onto the seed crystal 60.

The source chamber 30, passage 40 and growth chamber 50, may each be of constant cross-section, or may have a varying cross-section as required. In the preferred example shown in Figure 1, the source chamber 30, passage 40 and growth chamber 50 are in the form of a cylindrical tube with a generally constant cross-sectional area or diameter. However, the tube may instead be conical or have some other cross-sectional shape.

A flow restrictor 14 is provided in the passage 40. The flow restrictor 14, which may take the form of a capillary transport tube, a disc with a small hole, or sintered quartz disc, acts to control the flow of vapour from the source chamber 16 to the seed crystal 60.

In this example, the source chamber 30, passage 40 and growth chamber 50, including the source material 20 and seed crystal 60, are encased in a vacuum jacket 4. The vacuum jacked provides a clean environment within which the crystal is grown to help avoid contamination. However, the vacuum jacket is not essential. Alternatively, a vacuum jacket could be provided to cover the entire apparatus, including the furnace. This is not, however, preferred, as this will cause delays in operation of the system which the jacket is evacuated and whilst the temperature of the source chamber and growth chamber are raised to the required level. Further, where the heater is provided within the vacuum jacket, there is a risk of contamination of the crystal from the heater, and also the heater must be a specialised heater able to operate within a vacuum.

The arrangement of the source and growth chambers, the passage and the heater in Figure 1 is generally similar to that shown in WO 2008/142395. It will be appreciated that the other arrangements shown in WO 2008/142395 as well as arrangements shown in WO 99/10571 and WO 2006/090104, in particular with different numbers and relative locations of source chambers and/or growth chambers, the provision of different numbers of heaters, including separate heaters for each of the source chambers and growth chambers, and different arrangements of transport paths between the source and growth chambers, including or excluding flow restrictors, are equally suitable for the present invention.

In one example, the source material 20 may be a source of cadmium telluride which forms a cadmium telluride crystal on a cadmium telluride seed crystal. However, many other crystals may be grown on suitable seed crystals. Examples of crystals include cadmium zinc telluride (CZT) and cadmium manganese telluride.

Although the source material 20 is described as being a solid, the source material may be supplied as a vapour or as a liquid, for example indium which is liable to evaporate.

In the arrangement shown in Figure 1, the support 70 can be positioned within the growth chamber 50 when the heater 2 is not in operation. Here, the apparatus, and in particular the growth chamber 50, will be at a lower temperature, for example room temperature. When the support 70 and its seed crystal 60 are appropriately located, the heater 2 can be activated to heat the apparatus up to operational temperature to grow a crystal. Once a crystal has been grown, the heater 2 can be turned off and the apparatus, and in particular the growth chamber 50, can be cooled to a lower temperature and the support 70 together with its grown crystal can be removed from the apparatus. This procedure can be best seen Figures 2 to 6 which show a preferred embodiment of the present invention.

Figure 2 shows a cross-sectional view of a support 70 being loaded into a growth chamber, according to a first embodiment of the invention. In this embodiment, the support 70 is coupled to or mounted on an elongate shaft 176 and supports a seed crystal 60. As indicated by the arrow in Figure 2, the support 70 is positioned into the growth chamber 50. In this embodiment, the growth chamber 50 is a cylindrical tube, having an inner wall 152 and the support 70 is generally disk shaped. The support 70 and growth chamber 50 may, however, have any other suitable geometry.

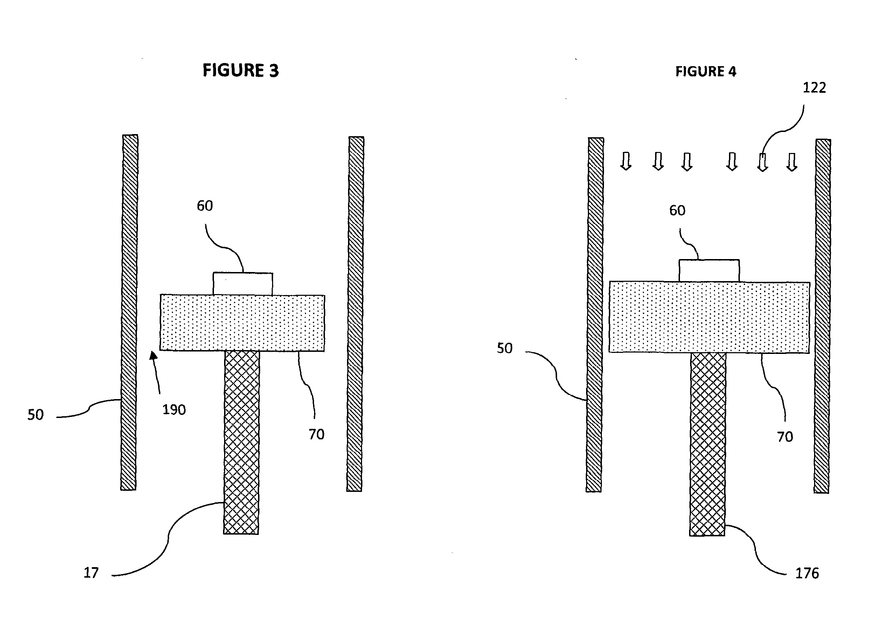

As can be seen in Figure 3, when the support 70 is positioned within the growth chamber 50, there exists a gap or spacing 190 between the side of the support 70 and the inner wall 152 of the growth chamber 50. Where the support 70 has a circular cross-sectional area and the growth chamber 50 is cylindrical, the gap between the support 70 and the inner walls of the growth chamber 50 has an annular profile. This helps to ensure a constant and regular flow of vapour over the seed 60.

In the embodiment shown in Figures 2 and 3, the heater (not shown) of the apparatus is not activated and the apparatus is at a lower temperature, in this case around room temperature. At this temperature, there is a relatively large gap 190 between the side of the support 70 and the inner wall 152 of the growth chamber 50. Therefore loading of the support 70 into the growth chamber can be achieved with relative ease and with minimal risk of the support 70 impacting against, and potentially damaging or suffering damage from, the side wall 152 of the growth chamber.

As best seen in Figures 3 and 4, once the support 70 has been appropriately positioned within the growth chamber 50, the heater can be activated such that the temperature of the apparatus will increase from ambient temperature (as shown in Figure 3) to operational temperature (as shown in Figure 4), for example around 490°C. The support 70 is formed from a material that has a coefficient of thermal expansion greater than that of the material from which the walls of the growth chamber 50 are formed. Therefore, as can be seen from Figure 4, when the temperature of the system is increased, the support 70 will expand with respect to the growth chamber 50 and therefore the annular gap between these two components will decrease. By appropriately selecting the materials and dimensions of the support 70 and the growth chamber 50, the apparatus can be calibrated such that, at operational temperature, the gap between the support 70 and the growth chamber 50 can be accurately reduced to provide precise desirable flow restriction.

In a particular example, the growth chamber is formed from quartz, and has an inner diameter at 293K of 51.500mm. A pedestal is included formed from sapphire with an outer diameter of 51.110mm at 273K. This provides an annulus between the outside of the pedestal and the inside of the growth tube of 0.390mm. When the apparatus is heated to an operational temperature of 1173K, the inner diameter of the growth tube expands to 51.525mm, whilst the outer diameter of the pedestal expands to 51.425mm, thereby reducing the annular gap from 0.390mm to 0.100mm.

In another example using a quartz tube and sapphire pedestal, where the inner diameter of the tube is 101.400mm at 293K and the outer diameter of the pedestal is 100.728mm at 293K, giving an annular gap of 0.671mm, an increase in temperature to 1173K increases the inner diameter of the tube to 101.449mm and increases the outer diameter of the pedestal to 101.349mm, again reducing the annular gap to 0.100mm.

It will therefore be seen that in both examples there is a relatively large gap between the outer surface of the pedestal and the inner surface of the tube at lower temperatures, allowing easy placement and removal of the pedestal within the growth tube, but as the temperature is increased to operational temperatures, the gap is greatly reduced to control the vapour flow at the point of growth.

Whilst the use of a quartz growth tube and a sapphire pedestal is merely one example of the possible materials that can be used in the present invention, it has been found that the use of a sapphire pedestal is particularly advantageous when growing cadmium telluride or cadmium zinc telluride crystals as neither cadmium telluride or cadmium zinc telluride vapour will condense on sapphire. This means that the gap between the pedestal and the tube does not get blocked or clogged with condensed vapour.

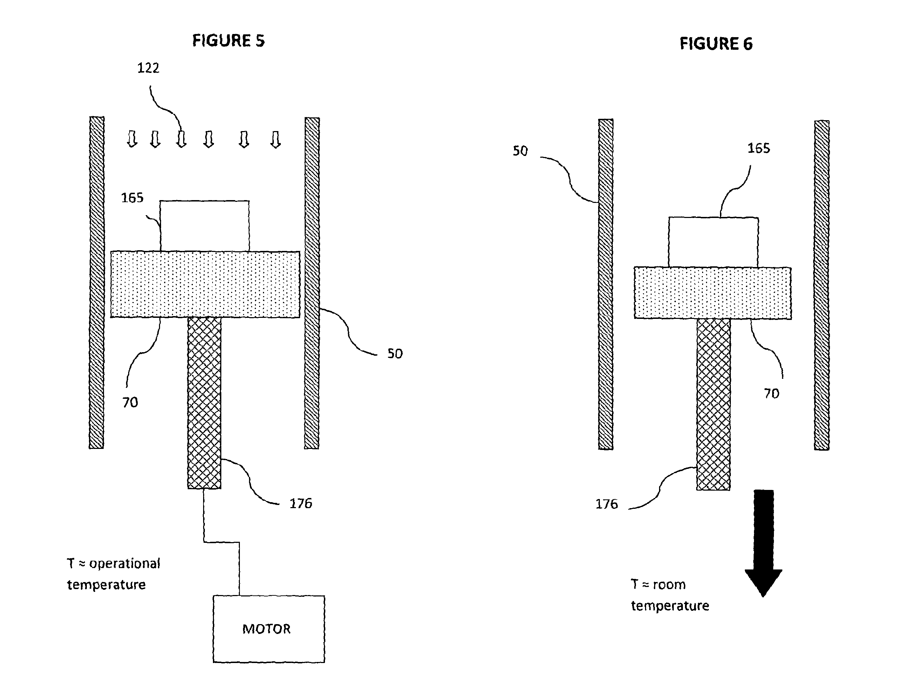

When the apparatus is at its operational temperature, the source material 20 will sublime to create vapour 122. This vapour will travel from the source chamber 30, via the passage 40 to the growth chamber 50, as a result of the temperature gradient created by the heater (not shown). As can be seen in Figure 4, the vapour 122 will flow towards the seed crystal 60 and begin to cause growth on the seed crystal 60. This is best seen in Figure 5, which shows a cross-sectional view of the support 70 when located in the growth chamber 50 after the apparatus has been at operational temperature for a period of time, such that some crystal growth has been achieved. The crystal grown may be of the same material as the seed, or may be different. Once crystal growth has been achieved, the heater can be switched off, thereby allowing the apparatus to cool back to a lower temperature. In some embodiments, a cooling device may also be used to increase the rate at which the apparatus cools to a lower temperature.

As the apparatus cools, the components will generally contract proportionally to their respective coefficients of thermal expansion. Since the support 70 has a coefficient of thermal expansion that is greater than that of the walls of the growth chamber 50, the support 70 will contract with respect to the walls of the growth chamber 50. This will therefore result in the annulus gap 190 increasing. As best seen in Figure 6, when the temperature of the apparatus has cooled to around room temperature, the support 70 will have contracted to approximately the same size as it was prior to being inserted into the growth tube 50 (Figure 2). This therefore allows for the support 70, together with its newly grown crystal 165 to be easily removed from the growth chamber 50, with minimal risk of the support 70 impacting against, and potentially damaging or suffering damage from, the side wall 152 of the growth chamber.

The grown crystal 165 can then be removed from the surface of the support 70 and replaced with a new seed crystal 60, and the support 70 can be re-inserted into the growth tube 50 in preparation for the growth of another crystal. Alternatively, a separate support having a seed crystal may be inserted into the growth chamber 50 to grow another crystal.

It will be appreciated that the support 70 does not necessarily need to be at or close to room temperature before being inserted or removed from the growth tube 50, and that the support 70 could instead be at a temperature above or below room temperature.

In the embodiment shown in Figure 5, the support 70 is coupled to an actuating means such that the upper surface of the support 70 can be moved as the crystal is grown. In this embodiment, the actuating means is a motor 5 which is coupled to the distal end of the elongate shaft 176. However, the actuating means may be manually driven or may be any other suitable component capable of causing such motion, for example a piezoelectric motor or a pneumatic motor.

By providing a motor 5 to cause movement of the support 70, the position of the upper surface of the crystal on which further crystal material is grown can be adjusted, and therefore its position in the temperature profile can be adjusted. This is of particular advantage when a thick crystal is being formed, as the height of the support can be gradually lowered as the crystal is formed to ensure that the uppers surface of the crystal remains at the same position in the temperature profile.

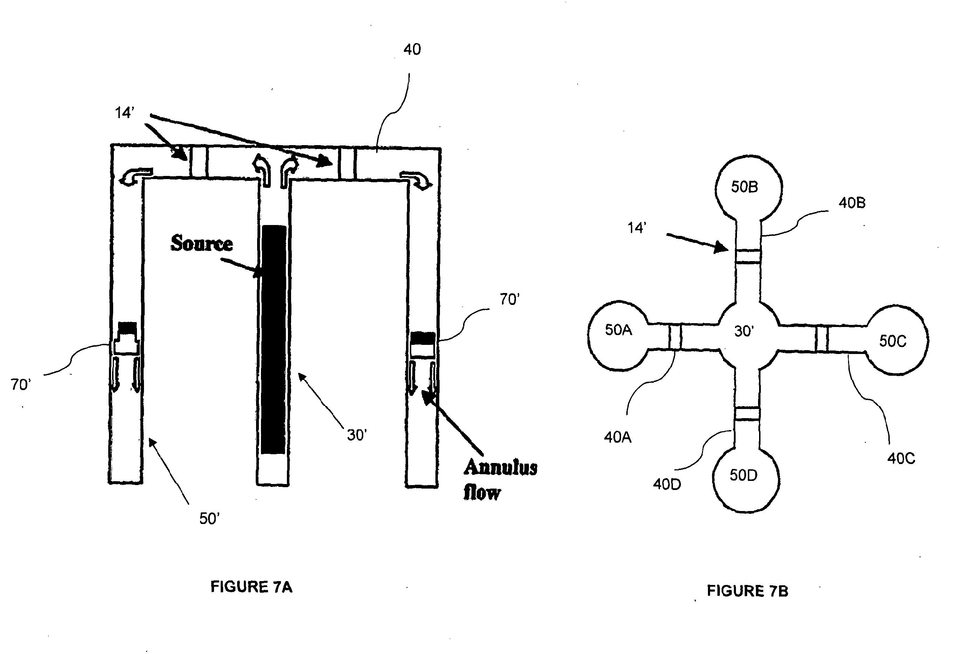

As noted above, other arrangements of source and/or growth chambers or tubes, including the provision of multiple source chambers and/or growth chambers, can be used with the support for the or each growth chamber having a greater thermal coefficient of expansion than the respective growth chamber. In an alternative embodiment shown in Figure 7, the apparatus includes additional growth chambers each provided with a respective support and corresponding seed crystal (not shown). In this particular embodiment, the apparatus includes three additional growth chambers 50B, 50C, 50D spaced laterally offset from the source chamber 30'; resulting in a total of four growth chambers 50A, 50B, 50C, 50D surrounding the source chamber 30'. However, any suitable number of additional growth chambers may be provided in any suitable arrangement. For example, the additional growth chambers may be positioned in line with the source chamber.

In this embodiment, the growth chambers 50A, 50B, 50C, 50D are mutually associated with a single source chamber 30 which is located centrally to the surrounding four growth chambers 50A, 50B, 50C, 50D. Each growth chamber is coupled to the source chamber via their respective passage 40A, 40B, 40C, 40D, each including a flow restrictor.

The supports 70' have a coefficient of thermal expansion which is greater than the coefficient of thermal expansion of their respective growth chambers 50A, 50B, 50C, 50D and can therefore be inserted and removed from their growth chambers in accordance with the method described in respect of Figure 2 to 6. Where the properties of the growth chambers 50A, 50B, 50C, 50D and their supports are the same, the apparatus of Figure 7 can be used to simultaneously grow a plurality of identical or near identical crystals. This is advantageous where mass production of identical or near identical crystals is desired.

Alternatively, the apparatus of Figure 7 can be used to simultaneously grow a plurality of crystals having different properties, such as different size, composition and/or quality. This could be achieved by providing different growing conditions in each of the growth chambers 50A, 50B, 50C, 50D and their corresponding passage 40A, 40B, 40C, 40D, such as different temperature profiles, different seed crystals and/or different upstream flow restrictor arrangements. However, this can also be achieved by arranging for the coefficient of thermal expansion of a support provided in one growth chamber to be different from the coefficient of thermal expansion of a support provided in another growth chamber. Here, the gap provided between the supports and their respective growth chambers could vary from chamber to chamber. As described above, the geometry of the gap provided will affect the flow properties of the vapour, and hence different gap geometries will result in different vapour flow in each chamber and therefore different crystals being grown in each chamber.

## Claims

1. An apparatus for crystal growth, the apparatus comprising:
a source chamber (30) configured to contain a source material (20);
a growth chamber (50);
a passage (40) for transport of vapour from the source chamber (30) to the growth chamber (50);
a support (70) provided within the growth chamber and configured to support a seed crystal (60); and
a gap (190) defined between the growth chamber (50) and the support (70);
wherein the coefficient of thermal expansion of the support (70) is greater than the coefficient of thermal expansion of the growth chamber, and wherein the materials and dimensions of the support and growth chamber are selected so that the gap (190) between the support and growth chamber is defined for an operational temperature, to provide a flow restriction function at that operational temperature.

2. An apparatus according to claim 1, in which the support (70) is movable with respect to the growth chamber (50) such that the upper surface of the support and hence the upper surface of the crystal can be moved as the crystal is grown.

3. An apparatus according to claim 2, in which the support (70) is coupled to or mounted on an elongate shaft (176).

4. An apparatus according to claim 3, in which the elongate shaft (176) has a coefficient of thermal expansion which is the same or similar as that of the support (70) or that of the growth chamber (50).

5. An apparatus according to any one of the preceding claims, in which the growth chamber (50) and the support (70) respectively have a generally circular cross-sectional area.

6. An apparatus according to any one of the preceding claims in which the growth chamber (50) is formed from quartz or from pyrolytic boron nitride.

7. An apparatus according to any one of the preceding claims, in which the support (70) is formed from sapphire, alumina, silicon carbide, tungsten, tantalum or molybdenum.

8. An apparatus according to any one of the preceding claims in which the growth chamber (50) is formed from quartz and the support (70) is formed from sapphire.

9. An apparatus according to claim 8 in which the growth chamber (50) has an inner diameter of around 51.500mm at 293K and the support has an outer diameter of around 51.110mm at 293K.

10. An apparatus according to claim 8 in which the growth chamber (50) has an inner diameter of around 101.400mm at 293K and the support has an outer diameter of around 100.728mm at 293K.

11. A method of providing an apparatus for growing a crystal, the method comprising the steps of:
providing a growth chamber (50) having a coefficient of thermal expansion;
providing a support (70) configured to support a seed crystal (60), the support having a coefficient of thermal expansion greater than the coefficient of thermal expansion of the growth chamber;
positioning the support within the growth chamber to define a gap (190) between support and the walls of the growth chamber;
heating the growth chamber (50) and the support (70) to an operational temperature such that the support expands with respect to the growth chamber to reduce the gap; and
selecting the materials and dimensions of the support and growth chamber so that the gap (190) between the support and growth chamber is defined for an operational temperature, to provide a flow restriction function at that operational temperature.

12. The method of claim 11, further comprising growing a crystal on the support.

13. The method of claim 11 or claim 12, further comprising cooling the growth chamber and the support once a crystal has been grown on the support, such that the support (70) contracts with respect to the growth chamber (50) to increase the gap (190).

## Patentansprüche

1. Eine Vorrichtung zur Kristallzüchtung, wobei die Vorrichtung Folgendes beinhaltet:
eine Quellenkammer (30), die konfiguriert ist, um ein Quellenmaterial (20) zu enthalten; eine Züchtungskammer (50);
einen Durchlass (40) zum Transport von Dampf aus der Quellenkammer (30) in die Züchtungskammer (50);
einen Träger (70), der innerhalb der Züchtungskammer bereitgestellt ist und konfiguriert ist, um einen Impfkristall (60) zu tragen; und
einen Abstand (190), der zwischen der Züchtungskammer (50) und dem Träger (70) definiert ist;
wobei der Wärmeausdehnungskoeffizient des Trägers (70) größer als der Wärmeausdehnungskoeffizient der Züchtungskammer ist, und wobei die Materialien und die Dimensionen des Trägers und der Züchtungskammer so ausgewählt sind, dass der Abstand (190) zwischen dem Träger und der Züchtungskammer für eine Betriebstemperatur definiert ist, um bei dieser Betriebstemperatur eine Fließbehinderungsfunktion bereitzustellen.

2. Vorrichtung gemäß Anspruch 1, wobei der Träger (70) in Bezug auf die Züchtungskammer (50) bewegbar ist, so dass die obere Fläche des Trägers und somit die obere Fläche des Kristalls bewegt werden können, während der Kristall gezüchtet wird.

3. Vorrichtung gemäß Anspruch 2, wobei der Träger (70) an eine längliche Welle (176) gekoppelt oder daran montiert ist.

4. Vorrichtung gemäß Anspruch 3, wobei die längliche Welle (176) einen Wärmeausdehnungskoeffizienten aufweist, der dem des Trägers (70) oder dem der Züchtungskammer (50) gleich oder ähnlich ist.

5. Vorrichtung gemäß einem der vorhergehenden Ansprüche, wobei die Züchtungskammer (50) und der Träger (70) jeweils einen im Allgemeinen kreisförmigen Querschnittsbereich aufweisen.

6. Vorrichtung gemäß einem der vorhergehenden Ansprüche, wobei die Züchtungskammer (50) aus Quarz oder aus pyrolytischem Bornitrid gebildet ist.

7. Vorrichtung gemäß einem der vorhergehenden Ansprüche, wobei der Träger (70) aus Saphir, Aluminiumoxid, Siliciumcarbid, Wolfram, Tantal oder Molybdän gebildet ist.

8. Vorrichtung gemäß einem der vorhergehenden Ansprüche, wobei die Züchtungskammer (50) aus Quarz gebildet und der Träger (70) aus Saphir gebildet ist.

9. Vorrichtung gemäß Anspruch 8, wobei die Züchtungskammer (50) bei 293 K einen Innendurchmesser von etwa 51,500 mm aufweist und der Träger bei 293 K einen Außendurchmesser von etwa 51,110 mm aufweist.

10. Vorrichtung gemäß Anspruch 8, wobei die Züchtungskammer (50) bei 293 K einen Innendurchmesser von etwa 101,400 mm aufweist und der Träger bei 293 K einen Außendurchmesser von etwa 100,728 mm aufweist.

11. Ein Verfahren zum Bereitstellen einer Vorrichtung zum Züchten eines Kristalls, wobei das Verfahren die folgenden Schritte beinhaltet:
Bereitstellen einer Züchtungskammer (50), die einen Wärmeausdehnungskoeffizienten aufweist;
Bereitstellen eines Trägers (70), der konfiguriert ist, um einen Impfkristall (60) zu tragen, wobei der Träger einen Wärmeausdehnungskoeffizienten aufweist, der größer als der Wärmeausdehnungskoeffizient der Züchtungskammer ist;
Positionieren des Trägers innerhalb der Züchtungskammer, um zwischen dem Träger und den Wänden der Züchtungskammer einen Abstand (190) zu definieren;
Erwärmen der Züchtungskammer (50) und des Trägers (70) auf eine Betriebstemperatur, so dass der Träger in Bezug auf die Züchtungskammer expandiert, um den Abstand zu verringern; und
Auswählen der Materialien und Dimensionen des Trägers und der Züchtungskammer, so dass der Abstand (190) zwischen dem Träger und der Züchtungskammer für eine Betriebstemperatur definiert ist, um bei dieser Betriebstemperatur eine Fließbehinderungsfunktion bereitzustellen.

12. Verfahren gemäß Anspruch 11, das ferner das Züchten eines Kristalls auf dem Träger beinhaltet.

13. Verfahren gemäß Anspruch 11 oder Anspruch 12, das ferner das Kühlen der Züchtungskammer und des Trägers, sobald auf dem Träger ein Kristall gezüchtet worden ist, so dass sich der Träger (70) in Bezug auf die Züchtungskammer (50) zusammenzieht, um den Abstand (190) zu vergrößern, beinhaltet.

## Revendications

1. Un appareil pour la croissance de cristaux, l'appareil comprenant :
une chambre de source (30) configurée afin de contenir une matière source (20) ;
une chambre de croissance (50) ;
un passage (40) pour le transport de vapeur de la chambre de source (30) à la chambre de croissance (50) ;
un support (70) fourni au sein de la chambre de croissance et configuré afin de supporter un germe cristallin (60) ; et
un intervalle (190) défini entre la chambre de croissance (50) et le support (70) ;
où le coefficient de dilatation thermique du support (70) est supérieur au coefficient de dilatation thermique de la chambre de croissance, et où les matières et les dimensions du support et de la chambre de croissance sont sélectionnées de manière que l'intervalle (190) entre le support et la chambre de croissance soit défini pour une température de fonctionnement, afin de fournir une fonction de restriction de débit à cette température de fonctionnement.

2. Un appareil selon la revendication 1, dans lequel le support (70) est mobile par rapport à la chambre de croissance (50) de telle manière que la surface supérieure du support, et donc la surface supérieure du cristal, puisse être déplacée au fur et à mesure que le cristal est amené à croître.

3. Un appareil selon la revendication 2, dans lequel le support (70) est couplé à ou monté sur un arbre allongé (176).

4. Un appareil selon la revendication 3, dans lequel l'arbre allongé (176) a un coefficient de dilatation thermique qui est identique ou similaire à celui du support (70) ou à celui de la chambre de croissance (50).

5. Un appareil selon l'une quelconque des revendications précédentes, dans lequel la chambre de croissance (50) et le support (70) ont respectivement une aire en coupe transversale généralement circulaire.

6. Un appareil selon l'une quelconque des revendications précédentes dans lequel la chambre de croissance (50) est formée à partir de quartz ou à partir de nitrure de bore pyrolytique.

7. Un appareil selon l'une quelconque des revendications précédentes, dans lequel le support (70) est formé à partir de saphir, d'alumine, de carbure de silicium, de tungstène, de tantale ou de molybdène.

8. Un appareil selon l'une quelconque des revendications précédentes dans lequel la chambre de croissance (50) est formée à partir de quartz et le support (70) est formé à partir de saphir.

9. Un appareil selon la revendication 8 dans lequel la chambre de croissance (50) a un diamètre interne d'environ 51,500 mm à 293 K et le support a un diamètre externe d'environ 51,110 mm à 293 K.

10. Un appareil selon la revendication 8 dans lequel la chambre de croissance (50) a un diamètre interne d'environ 101,400 mm à 293 K et le support a un diamètre externe d'environ 100,728 mm à 293 K.

11. Une méthode pour fournir un appareil destiné à faire croître un cristal, la méthode comprenant les étapes consistant à :
fournir une chambre de croissance (50) ayant un coefficient de dilatation thermique ;
fournir un support (70) configuré afin de supporter un germe cristallin (60), le support ayant un coefficient de dilatation thermique supérieur au coefficient de dilatation thermique de la chambre de croissance ;
positionner le support au sein de la chambre de croissance afin de définir un intervalle (190) entre le support et les parois de la chambre de croissance ;
chauffer la chambre de croissance (50) et le support (70) jusqu'à une température de fonctionnement de telle manière que le support se dilate par rapport à la chambre de croissance afin de réduire l'intervalle ; et
sélectionner les matières et les dimensions du support et de la chambre de croissance de manière que l'intervalle (190) entre le support et la chambre de croissance soit défini pour une température de fonctionnement, afin de fournir une fonction de restriction de débit à cette température de fonctionnement.

12. La méthode de la revendication 11, comprenant en sus le fait de faire croître un cristal sur le support.

13. La méthode de la revendication 11 ou de la revendication 12, comprenant en sus le fait de refroidir la chambre de croissance et le support une fois qu'un cristal a été amené à croître sur le support, de telle manière que le support (70) se contracte par rapport à la chambre de croissance (50) afin d'agrandir l'intervalle (190).
